# EUROPÄISCHE PATENTANMELDUNG

(11) **EP 4 524 282 A2**
(43) Veröffentlichungstag der Anmeldung: **19.03.2025**
(21) Anmeldenummer: 24192386.1
(22) Anmeldetag: 01.08.2024
(51) Int. Cl.: C23C 14/00, C23C 14/34, C23C 14/35

(54) **VERFAHREN ZUR OBERFLÄCHENBESCHICHTUNG NACH DEM SPUTTERPRINZIP**

(30) Priorität: 11.09.2023 DE 102023124377
(71) Anmelder: Eltro GmbH, 52499 Baesweiler (DE)
(72) Erfinder: Strämke, Marc, 52499 Baesweiler (DE)
(74) Vertreter: dompatent von Kreisler Selting Werner - Partnerschaft von Patent- und Rechtsanwälten mbB

(57) **Zusammenfassung**

Bei einem Verfahren zur Oberflächenbeschichtung nach dem Sputterprinzip mit einer Plasmabeschichtungsvorrichtung (10), wobei die Plasmabeschichtungsvorrichtung (10) aufweist: eine von einer Vakuumpumpe (14) evakuierbare Vakuumkammer (12), mindestens eine in der Vakuumkammer (12) angeordnete Sputterquelle (18, 18a, 18b, 18c) mit einem Target (20) aus einem Festkörpermaterial, ein zu beschichtendes Substrat in der Vakuumkammer (12) und mindestens eine in die Vakuumkammer (12) mündende Trägergasquelle (22, 22a, 22b, 22c), die dazu ausgebildet ist, einen auf die Sputterquelle gerichteten Trägergasstrom zu erzeugen, mit den Schritten: Evakuieren der Vakuumkammer (12), Zuführen eines Trägergasstroms aus der Trägergasquelle (22, 22a, 22b, 22c) zu dem Target (20) derart, dass innerhalb der Vakuumkammer (12) im Bereich des Targets (20) ein Plasma mit Ionen aus Atomen des Trägergases erzeugt wird, wobei die Plasma-Ionen Teilchen aus dem Festkörpermaterial des Targets (20) herauslösen und die herausgelösten Teilchen als Teilchenstrom der Oberfläche des Substrats (16) zugeführt werden, ist vorgesehen, dass der Trägergasstrom dem Target (20) der Sputterquelle (18, 18a, 18b, 18c) diskontinuierlich zugeführt wird, indem der Gasfluss des Trägergasstroms moduliert wird.

## Beschreibung

Die Erfindung betrifft ein Verfahren zur Oberflächenbeschichtung nach dem Sputterprinzip mit einer Plasmabeschichtungsvorrichtung.

Bei der Plasmabeschichtung nach dem Sputterprinzip, auch "Sputtern" genannt, wird ein als Target bezeichneter Festkörper verdampft, bei dem es sich z. B. um ein Metall handeln kann, wodurch ein Plasma erzeugt wird, um Teilchen des Festkörpers auf einem Substrat abzuscheiden, wodurch das Substrat beschichtet wird.

Eine Plasmabeschichtungsvorrichtung zur Oberflächenbeschichtung nach dem Sputterprinzip weist eine Vakuumkammer auf, die von einer Vakuumpumpe evakuiert wird und in der das zu beschichtende Substrat platziert wird. In der Vakuumkammer ist mindestens eine Sputterquelle angeordnet, die ein Target aus einem Festkörpermaterial aufweist.

Bei einem als "Gasflusssputtern" bezeichneten Verfahren, erfolgt das Sputtern unter Verwendung eines Trägergases, welches der Vakuumkammer zugeführt wird. Bei dem Trägergas handelt es sich meist um ein Edelgas, wie z. B. Argon. Die Plasmabehandlungsvorrichtung weist hierzu mindestens eine in die Vakuumkammer mündende Trägergasquelle auf, mit der ein auf die Sputterquelle gerichteter Trägergasstrom erzeugt wird. Aus Atomen des Trägergases wird im Bereich des Targets ein Plasma erzeugt. Die Ionen des Plasmas lösen Teilchen aus dem Festkörpermaterial des Targets heraus. Die herausgelösten Teilchen werden als vorzugsweise gerichteter Teilchenstrom der Oberfläche des Substrats zugeführt, so dass die Teilchen auf einer Oberfläche des Substrats abgeschieden werden und dort eine Schicht bilden.

Das Beschichten von Oberflächen nach dem Sputterprinzip erfordert typischerweise einen niedrigen Druck im Beschichtungsraum, also innerhalb der Vakuumkammer, um einen kollisionsfreien Transport des erzeugten Dampfes auf das Substrat zu ermöglichen. Höhere Drücke führen zur Bildung von größeren Teilchen sowie zu einer Streuung des Dampfes in alle Raumrichtungen und somit zu Materialverlust.

Das Gasflusssputtern unter Verwendung eines Trägergases ist beispielsweise in DE 42 10 125 C2 beschrieben. Neben dem Kathodenzerstäuben wird im Stand der Technik ein Lichtbogenverdampfen zur Beschichtung eingesetzt. Vorteilhaft ist dabei die Erzeugung eines Stroms geladener Teilchen, welche im Beschichtungsprozess zu verbesserten Schichteigenschaften und erhöhter Schichthaftung führen.

Des Weiteren ist im Stand der Technik bei einer Glimmentladung zur Erhöhung der Stromdichte ein Überlagern der Entladung mit einem Magnetfeld beschrieben ("Magnetronsputtern").

Zur Erhöhung des Ionisationsgrades beim Magnetronsputtern wird beispielsweise in EP 1 038 045 B1 ein als Hochleistungsimpuls-Magnetronsputtern (HIPIMS) beschrieben, bei dem eine elektrische Modulation der Entladung vorgenommen wird, mit dem Ziel, die Stromdichte und damit den Ionisationsgrad zu steigern. EP 1 038 045 B1 beschreibt dabei, der Vakuumpumpe ein Reaktivgas moduliert diskontinuierlich zuzuführen.

Beim Gasflusssputtern führt eine Erhöhung des Trägergasflusses zu einer Steigerung der Abscheiderate. Allerdings erfordern hohe Trägergasgeschwindigkeiten besonders leistungsstarke Vakuumpumpen, um den erforderlichen Vakuumdruck innerhalb der Vakuumkammer aufrecht zu erhalten.

Vor diesem Hintergrund liegt der Erfindung die Aufgabe zugrunde, ein verbessertes Verfahren zur Oberflächenbeschichtung nach dem Prinzip des Gasflusssputterns mit hoher Abscheiderate bereit zu stellen.

Das erfindungsgemäße Verfahren wird definiert durch die Merkmale von Patentanspruch 1.

Demnach erfolgt die Oberflächenbeschichtung mit einer Plasmabeschichtungsvorrichtung, die aufweist:
eine von einer Vakuumpumpe evakuierbare Vakuumkammer,
mindestens eine in der Vakuumkammer angeordnete Sputterquelle mit einem Target aus einem Festkörpermaterial,
ein zu beschichtendes Substrat in der Vakuumkammer und
mindestens eine in die Vakuumkammer mündende Trägergasquelle, die dazu ausgebildet ist, einen auf die Sputterquelle gerichteten Trägergasstrom zu erzeugen.

Nach dem erfindungsgemäßen Verfahren wird die Vakuumkammer evakuiert und aus der Trägergasquelle wird der Vakuumkammer ein Trägergasstrom zu dem Target derart zugeführt, dass innerhalb der Vakuumkammer im Bereich des Targets ein Plasma mit Ionen aus Atomen des Trägergases erzeugt wird ("Gasflusssputtern"), wobei die Plasma-Ionen Teilchen aus dem Festkörpermaterial des Targets herauslösen und die herausgelösten Teilchen als Teilchenstrom, vorzugsweise gerichtet, der Oberfläche des Substrats zugeführt werden. Die herausgelösten Teilchen werden dadurch auf der Oberfläche des Substrats abgeschieden und bilden dort eine Schicht.

Die Besonderheit der Erfindung besteht darin, dass der Trägergasstrom dem Target der Sputterquelle diskontinuierlich zugeführt wird, indem der Gasfluss des Trägergasstroms moduliert wird. Das Trägergas wird also mit moduliertem Gasfluss zugeführt. Während herkömmlicherweise der Trägergasfluss kontinuierlich, d. h. mit kontinuierlicher Gasflussgeschwindigkeit, zugeführt wird und zur Erhöhung der Geschwindigkeit die kontinuierliche Gasflussgeschwindigkeit erhöht wird, soll erfindungsgemäß der Gasfluss des Trägergases moduliert werden, d. h. mit zeitlichem Verlauf variieren. Der über die Zeit gemittelte Trägergasfluss, d. h. der durchschnittliche Gasfluss, ist dadurch dann geringer als der Trägergasfluss während bestimmter zeitlicher Abschnitte der Modulation. Die zeitlichen Abschnitte mit gegenüber dem mittleren Gasfluss erhöhtem Gasfluss des Trägergasstroms werden vorliegend als "Peaks" bezeichnet. Ein Peak erhöht dabei den Materialeintrag auf das zu beschichtende Substrat, weil der Gasfluss des Trägergases während eines Peaks erhöht ist.

Die Erfindung basiert auf der überraschenden, für einen Fachmann nicht zu erwartenden Erkenntnis, dass die Abscheiderate, d. h. der Materialeintrag auf das Substrat, bei einem modulierten Trägergasfluss insgesamt höher ist als bei einem kontinuierlichen Trägergasstrom, dessen Gasfluss dem gemittelten Trägergasfluss des modulierten Gasstromes entspricht. Die Erfindung bewirkt damit den entscheidenden Vorteil, dass durch das Modulieren des Trägergasflusses die Abscheiderate auf das Substrat erhöht werden kann, ohne dabei die mittlere Geschwindigkeit bzw. den mittleren Gasfluss des Trägergasstroms zu erhöhen. Vielmehr ist ein erhöhter Gasfluss lediglich während einzelner, wiederkehrender Peaks ausreichend, während der mittlere Gasfluss unverändert oder nur geringfügig erhöht bleiben kann.

Vorliegend wird das Zuführen eines Trägergasstroms zu dem Target aus einer Trägergasquelle von dem Zuführen eines Reaktivgases aus einer Reaktivgasquelle unterschieden. Das Zuführen eines Trägergasstroms ist zwingender Bestandteil des Gasflusssputterns, um aus dem Trägergas ein Plasma zu erzeugen, das Teilchen aus dem Target herauslöst. Ein solches Trägergas ist typischerweise ein Edelgas, wie z. B. Argon. Davon zu unterscheiden ist das Zuführen eines Reaktivgases, was aus dem Stand der Technik bekannt ist, damit das Reaktivgas mit dem aus dem Trägergas erzeugten Plasma reagiert. Ein Modulieren eines der Vakuumkammer zugeführten Reaktivgasstroms ist nicht Gegenstand der Erfindung.

Das Modulieren des Trägergasstroms kann durch Schalten von einem oder mehreren Ventilen in einer Zuführleitung der Trägergasquelle erfolgen. Denkbar ist eine Zuführleitung der Trägergasquelle, die der Trägergasquelle das Trägergas zuführt, mit mindestens zwei parallel geschalteten Sperrventilen oder Proportionalventilen, um durch abwechselndes Schalten der Ventile verschiedene Flussgeschwindigkeiten oder variierenden Durchfluss des Trägergaststroms zu bewirken.

Das Modulieren des Trägergasflusses kann durch Amplitudenmodulation erfolgen, indem die Trägergaszufuhr beispielsweise ein- und ausgeschaltet wird. Die Modulation erfolgt in wiederkehrenden Phasen, wobei die Amplitude des Trägergasflusses in mindestens einer der Phasen einer Modulationsperiode gegenüber der Amplitude in einer anderen Phase deutlich erhöht oder reduziert sein sollte, mindestens um den Faktor 3 erhöht oder reduziert.

Hierzu kann die elektrische Versorgung der Sputterquelle und/oder des Substrates moduliert, insbesondere gepulst werden, z.B. in der vom HIPIMS Verfahren bekannten Art. Dabei kann beispielsweise die elektrische Versorgungsspannung oder die elektrische Leistung moduliert werden. Die Modulation der Spannung oder der Leistung kann asynchron zur Gasflussmodulation oder alternativ besonders bevorzugt synchron zu dieser erfolgen.

Die Frequenz der Modulation sollte derart gewählt werden, dass der Druck innerhalb der Vakuumkammer während einer Modulationsperiode nicht um mehr als circa 50 % und bevorzugt nicht um mehr als circa 20 % ansteigt. Mit "circa" ist vorliegend eine Abweichung von bis zu etwa +/- 5 % gemeint. Die Modulationsfrequenz sollte mindestens 0,1 Hz, vorzugsweise mindestens 0,5 Hz betragen, so dass eine Modulationsperiode nicht länger als 10 Sekunden, vorzugsweise nicht länger als 2 Sekunden dauern sollte.

Innerhalb der Vakuumkammer sollte der Druck so eingestellt werden, dass im Bereich der Trägergasquelle und im Bereich des Targets ein höherer Druck herrscht als im Bereich des Substrats, um einen Teilchenstrom von der Trägergasquelle und vom Target zum Substrat zu fördern. Von Vorteil ist wenn der Druck innerhalb der Vakuumkammer im Bereich des Targets so hoch eingestellt wird, dass die aus dem Target herausgelösten Teilchen mit dem Trägergas kollidieren. Der Druck im Bereich des Targets kann hierzu beispielsweise auf mindestens 0,05 mbar oder vorzugsweise mindestens 0,2 mbar eingestellt werden.

Die Oberflächenbeschichtung kann nach dem Prinzip der Kathodenzerstäubung erfolgen, bei dem jede Sputterquelle bzw. jedes Target eine Kathode bildet, deren Potenzial gegenüber demjenigen des in der Vakuumkammer erzeugten Plasmas bzw. gegenüber demjenigen der Vakuumkammer abgesenkt ist. Auch das Potential des zu beschichtenden Substrats kann abgesenkt sein, so dass auch das Substrat eine Kathode bildet.

Jede Sputterquelle kann dabei als Hohlkathode ausgebildet sein. Dabei kann die Trägergaszufuhr vorzugsweise direkt in das Innere jeder Hohlkathode erfolgen. Die Hohlkathode kann becherförmig mit einem Boden und einer weitgehend, d.h. über etwa 90-95 % des Umfangs, umlaufenden Mantelfläche ausgebildet sein. Die Trägergaszufuhr kann dabei durch den Boden in das Innere der Hohlkathode erfolgen. Die Trägergasquelle ist dann im Boden der Hohlkathode ausgebildet. Vorzugsweise ist der Boden auf anodischem Potential, um einen Abtrag des Bodens zu vermeiden. Andere langgestreckte, hohle Formen sind ebenfalls denkbar, wie z.B. hohlzylindrisch, hohlprismatisch, hohlquaderförmig, etc.

Die Hohlkathode ist vorzugsweise langgestreckt mit einer Öffnungsweite, die geringer ist als etwa ein Drittel ihrer Tiefe oder Länge in Gasflussrichtung. Als Öffnungsweite wird vorliegend der Innendurchmesser oder der minimale Abstand zwischen einander gegenüberliegenden Innenwänden in einem quer zur Längsrichtung angeordneten Querschnitt verstanden.

Erfindungsgemäß ist mit dem Ausdruck "eine in der Vakuumkammer angeordnete Sputterquelle" gemeint, dass die Sputterquelle innerhalb der Vakuumkammer oder innerhalb einer Gehäusewand der Vakuumkammer angeordnet sein kann. Die Sputterquelle kann an einer Wand der Vakuumkammer befestigt sein, in die Wand integriert sein und/oder aus der Wand in das Innere der Vakuumkammer hineinragen.

Alternativ ist ebenfalls denkbar, das erfindungsgemäße Verfahren zur Oberflächenbeschichtung mit einem magnetischen Sputterverfahren, z. B. nach dem Prinzip des Magnetron-Sputterns, auszuführen. Weiter denkbar wäre das Prinzip des Gleichspannungs-(DC-)Sputterns, Trioden-Sputterns, Hochfrequenz-(HF-)Sputterns, Atomstrahlsputterns oder Ionenstrahlsputterns.

Vorteilhafterweise wird die Erfindung kombiniert mit einem gepulsten Sputterverfahren bei dem die elektrische Energiezufuhr moduliert, bevorzugt gepulst, erfolgt. Die Modulation kann asynchron zur Gasmodulation oder bevorzugt synchron zur Gasmodulation erfolgen.

Erfindungsgemäß ist des Weiteren denkbar, mehrere Sputterquellen und/oder mehrere Trägergasquellen zu verwenden, wobei vorzugsweise jeder Sputterquelle eine eigene Trägergasquelle zugeordnet ist, so dass jedes Target von einer anderen Trägergasquelle mit Trägergas versorgt wird.

Alternativ oder ergänzend ist denkbar, dass eine Reaktivgasquelle in die Vakuumkammer mündet, um der Vakuumkammer ein von dem Trägergas verschiedenes Reaktivgas zuzuführen, welches mit dem Plasma innerhalb der Vakuumkammer reagiert.

Im Folgenden werden anhand der Figuren Ausführungsbeispiele der Erfindung näher erläutert. Es zeigen:
- Fig. 1: ein erstes Ausführungsbeispiel,
- Fig. 2: ein zweites Ausführungsbeispiel,
- Fig. 3: ein drittes Ausführungsbeispiel,
- Fig 4: ein viertes Ausführungsbeispiel und
- Fig. 5: ein zeitliches Diagramm der Trägergasmodulation.

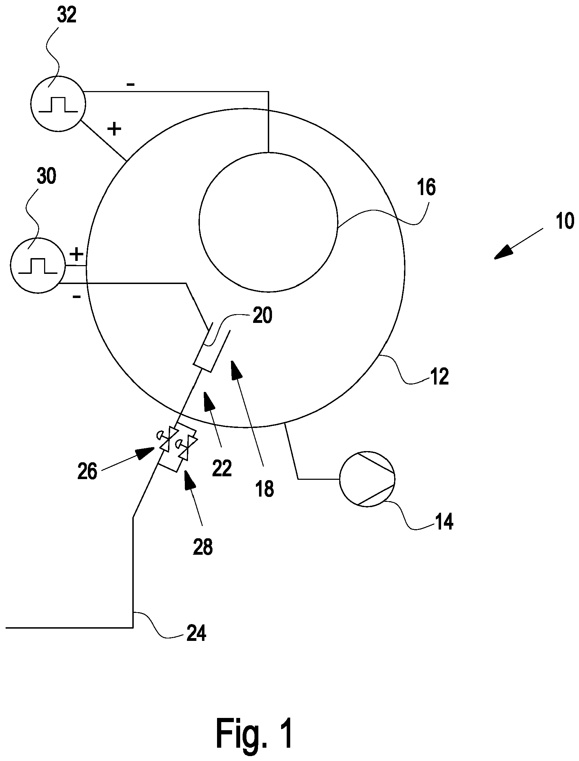

Die Ausführungsbeispiele gemäß den Fign. 1 - 4 zeigen jeweils eine Plasmabeschichtungsvorrichtung 10 mit einer Vakuumkammer 12, die auch als Prozesskammer oder Behandlungskammer bezeichnet werden kann. Die Vakuumkammer 12 wird von einer Feinvakuumpumpe 14 evakuiert. In der Vakuumkammer 12 jedes Ausführungsbeispiels ist ein Substrat 16 angeordnet, das beschichtet werden soll. Bei dem Substrat 16 kann es sich um ein oder mehrere Werkstücke oder andere zu beschichtende Objekte handeln, die der Vakuumkammer 12 zugeführt werden und nach erfolgter Beschichtung wieder aus der Vakuumkammer 12 entfernt werden.

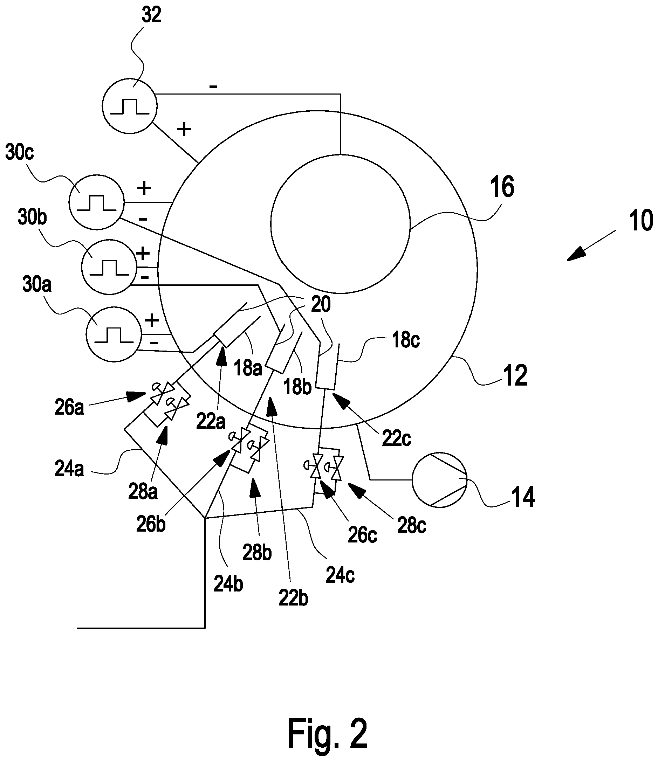

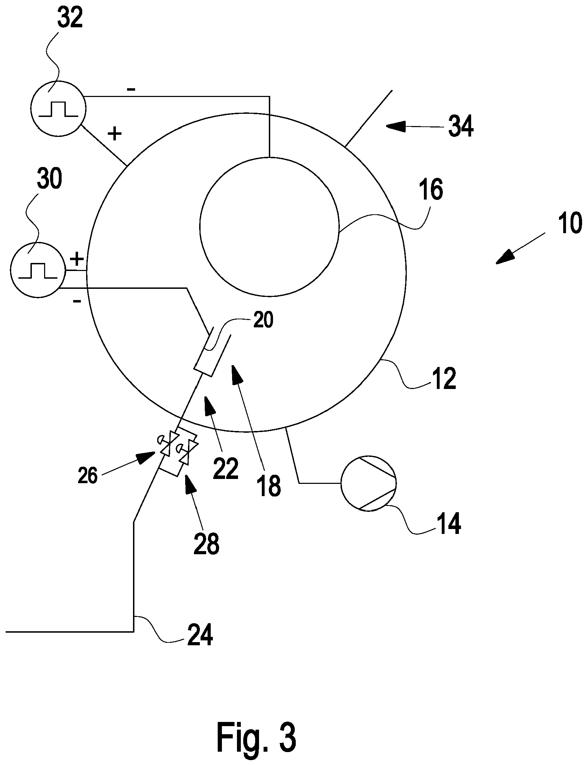

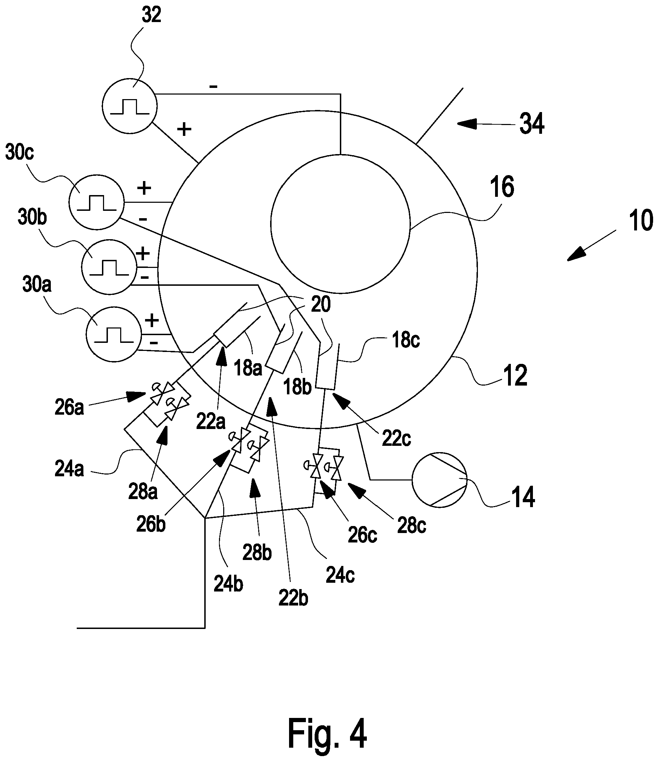

Bei den Ausführungsbeispielen nach den Fign. 1 und 3 ist in der Vakuumkammer 12 genau eine Sputterquelle 18 angeordnet, während bei den Ausführungsbeispielen der Fign. 2 und 4 mehrere, nämlich drei Sputterquellen 18a, 18b, 18c vorgesehen sind. Jede Sputterquelle 18, 18a, 18b, 18c ist als Hohlkathode ausgebildet, deren umlaufende Mantelfläche ein Target 20 bildet. Das Target 20 ist aus einem Festkörpermaterial, vorzugsweise einem Metall. In den Boden der Sputterquelle 18, 18a, 18b, 18c mündet jeweils eine der jeweiligen Sputterquelle zugeordnete Trägergasquelle 22, 22a, 22b, 22c, die aus einer Zuführleitung 24 mit Trägergas in Form eines Edelgases, wie z. B. Argon, gespeist wird.

Bei den Ausführungsbeispielen nach den Fign. 2 und 4 mit jeweils drei Trägergasquellen 22a, 22b, 22c teilt sich die Zuführleitung 24 in entsprechende Zuführzweige 24a, 24b, 24c auf, wobei jeder der Zuführzweige 24a, 24b, 24c genau eine entsprechende Trägergasquelle 22a, 22b, 22c versorgt. Bei den Ausführungsbeispielen nach den Fign. 1 und 3 sind in jeder Zuführleitung 24 und bei den Ausführungsbeispielen nach den Fign. 2 und 4 in jedem Zuführzweig 24a, 24b, 24c zwei schaltbare Ventile 26, 28 bzw. 26a, 28a; 26b, 28b; 26c, 28c parallel zueinander geschaltet, um die Modulation der Trägergaszufuhr zu der jeweiligen Trägergasquelle 22, 22a, 22b, 22c variieren zu können. Bei den Ventilen kann es sich um Sperrventile oder um Proportionalventile handeln. Bei den dargestellten Ausführungsbeispielen ist die Anzahl der Ventile pro Zuführleitung bzw. pro Zuführzweig lediglich beispielhaft. Stattdessen ist auch nur ein Ventil pro Zuführleitung in den Fign. 1 und 3 oder pro Zuführzweig in den Fign. 2 und 4 denkbar, z.B. als Proportionalventil.

Jede Sputterquelle bzw. jedes Target ist als Kathode ausgebildet und an den negativen Anschluss an einer entsprechenden Spannungsversorgungsquelle 30, bzw. 30a, 30b, 30c angeschlossen. Der positive Anschluss der jeweiligen Spannungsversorgungsquelle 30, 30a, 30b, 30c ist mit dem Gehäuse der Vakuumkammer 12 verbunden. In entsprechender Weise ist auch das Target an den negativen Anschluss einer weiteren Spannungsversorgungsquelle 32 angeschlossen, deren positiver Anschluss mit der Vakuumkammer 12 verbunden ist. Dadurch bildet auch das Substrat 16 eine Kathode, während das Gehäuse bzw. die Gehäusewand der Vakuumkammer 12 eine Anode bildet.

Die Ausführungsbeispiele der Fign. 3 und 4 unterscheiden sich von denjenigen in den Fign. 1 und 2 jeweils durch einen zusätzlichen Anschluss einer Reaktivgasquelle 34 an die Vakuumkammer 12.

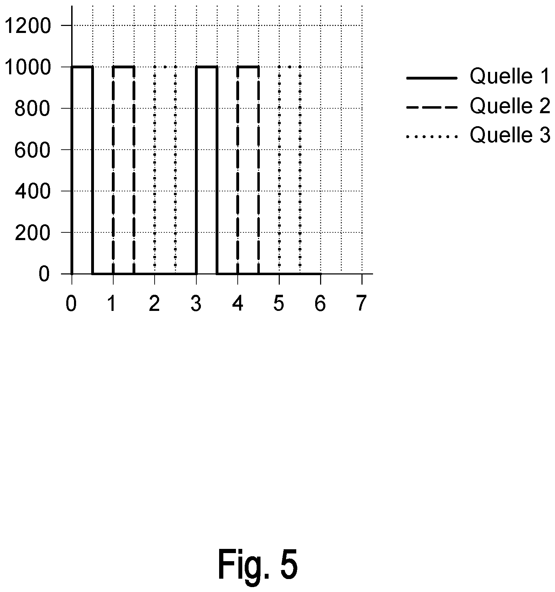

Für die Zufuhr von Trägergas in die Vakuumkammer 12 bzw. zu der jeweiligen Sputterquelle 18 bzw. 18a, 18b, 18c ergibt sich das in Fig. 5 dargestellte Diagramm. Die durchgezogene Linie entspricht dem modulierten Verlauf des Trägergasflusses der Trägergasquelle 22 in den Fign. 1 und 3 bzw. der Trägergasquelle 22a in den Fign. 2 und 4. Der gestrichelte Verlauf entspricht dem resultierenden Verlauf des modulierten Trägergasflusses der Trägergasquelle 22b in den Fign. 2 und 4. In entsprechender Weise stellt der gepunktete Verlauf in Fig. 5 den resultierenden Verlauf des modulierten Trägergasflusses der Trägergasquelle 22c in den Fign. 2 und 4 dar. Aus Fig. 5 ist erkennbar, dass durch abwechselndes Schalten der Ventile 26a, 28a; 26b, 28b; 26c, 28c ein gepulster Verlauf des zugeführten Trägergasstromes in die Vakuumkammer resultiert.

## Patentansprüche

1. Verfahren zur Oberflächenbeschichtung nach dem Sputterprinzip mit einer Plasmabeschichtungsvorrichtung (10), wobei die Plasmabeschichtungsvorrichtung (10) aufweist:
eine von einer Vakuumpumpe (14) evakuierbare Vakuumkammer (12),
mindestens eine in der Vakuumkammer (12) angeordnete Sputterquelle (18, 18a, 18b, 18c) mit einem Target (20) aus einem Festkörpermaterial,
ein zu beschichtendes Substrat in der Vakuumkammer (12) und mindestens eine in die Vakuumkammer (12) mündende Trägergasquelle (22, 22a, 22b, 22c), die dazu ausgebildet ist, einen auf die Sputterquelle gerichteten Trägergasstrom zu erzeugen,
mit den Schritten:
Evakuieren der Vakuumkammer (12),
Zuführen eines Trägergasstroms aus der Trägergasquelle (22, 22a, 22b, 22c) zu dem Target (20) derart, dass innerhalb der Vakuumkammer (12) im Bereich des Targets (20) ein Plasma mit Ionen aus Atomen des Trägergases erzeugt wird, wobei die Plasma-Ionen Teilchen aus dem Festkörpermaterial des Targets (20) herauslösen und die herausgelösten Teilchen als Teilchenstrom der Oberfläche des Substrats (16) zugeführt werden,
**dadurch gekennzeichnet,**
**dass** der Trägergasstrom dem Target (20) der Sputterquelle (18, 18a, 18b, 18c) diskontinuierlich zugeführt wird, indem der Gasfluss des Trägergasstroms moduliert wird.

2. Verfahren nach Anspruch 1, **dadurch gekennzeichnet, dass** der Trägergasfluss durch Variieren der Amplitude des Trägergasflusses moduliert wird.

3. Verfahren nach Anspruch 2, **dadurch gekennzeichnet, dass** die Modulation in wiederkehrenden Phasen derart erfolgt, dass die Amplitude mindestens einer Phase des Trägergasflusses mindestens um einen Faktor 3 gegenüber der Amplitude in einer anderen Phase erhöht oder reduziert ist.

4. Verfahren nach einem der vorhergehenden Ansprüche, **dadurch gekennzeichnet, dass** die Modulation des Trägergasflusses mit einer Modulationsfrequenz derart erfolgt, dass der Druck in der Vakuumkammer (12) nicht um mehr als 50 %, insbesondere 20 % während einer Periode der Modulation ansteigt.

5. Verfahren nach Anspruch 4, **dadurch gekennzeichnet, dass** die Modulationsfrequenz größer ist als 0,1 Hz, inbesondere größer 0,5 Hz ist.

6. Verfahren nach einem der vorhergehenden Ansprüche, **dadurch gekennzeichnet, dass** das Modulieren des Trägergasflusses durch Betätigen mindestens eines Ventils in einer Zuführleitung (24) der Trägergasquelle (22, 22a, 22b, 22c) erfolgt.

7. Verfahren nach einem der vorhergehenden Ansprüche, **dadurch gekennzeichnet, dass** die Plasmabeschichtungsvorrichtung (10) mehrere Sputterquellen (18, 18a, 18b, 18c) aufweist, wobei der jeder Sputterquelle (18, 18a, 18b, 18c) zugeführte Trägergasstrom moduliert wird.

8. Verfahren nach Anspruch 7, **dadurch gekennzeichnet, dass** jeder Sputterquelle (18, 18a, 18b, 18c) eine separate Trägergasquelle (22, 22a, 22b, 22c) zugeordnet ist, wobei der Trägergasstrom jeder Trägergasquelle (22, 22a, 22b, 22c) der jeweiligen Sputterquelle (18, 18a, 18b, 18c) zugeführt wird.

9. Verfahren nach einem der vorhergehenden Ansprüche, **dadurch gekennzeichnet, dass** die Plasmabeschichtungsvorrichtung (10) zudem eine in die Vakuumkammer (12) mündende Reaktivgasquelle (34) aufweist, aus der der Vakuumkammer (12) ein Reaktivgas zugeführt wird, welches innerhalb der Vakuumkammer (12) mit dem von dem Trägergas erzeugten Teilchenstrom reagiert.

10. Verfahren nach Anspruch 1, **dadurch gekennzeichnet, dass** das Evakuieren der Vakuumkammer (12) während der Oberflächenbeschichtung auf einen Druck von weniger als 0,4 mbar erfolgt.

11. Verfahren nach Anspruch 1, **dadurch gekennzeichnet, dass** das Verfahren nach dem Prinzip der Kathodenzerstäubung erfolgt, wobei jedes Target eine Kathode bildet.

12. Verfahren nach Anspruch 11, **dadurch gekennzeichnet, dass** das Gehäuse der Vakuumkammer (12) eine Anode und das Substrat eine weitere Kathode bilden.

13. Verfahren nach Anspruch 11 oder 12, **dadurch gekennzeichnet, dass** jede Sputterquelle (18, 18a, 18b, 18c) als Hohlkathode ausgebildet ist.

14. Verfahren nach einem der Ansprüche 11-13, **dadurch gekennzeichnet, dass** die elektrische Versorgung der Sputterquelle und/oder des Substrates moduliert wird.

15. Verfahren nach einem der Ansprüche 1 - 10, **dadurch gekennzeichnet, dass** die Oberflächenbeschichtung durch ein magnetisches Sputterverfahren, z. B. dem Magnetron-Sputtern, oder nach dem Prinzip des Ionenstrahlsputterns, des Atomstrahlsputterns, des Hochfrequenzsputterns oder des Gleichspannungssputterns erfolgt.

16. Verfahren nach einem der vorhergehenden Ansprüche, **dadurch gekennzeichnet, dass** das Zuführen des Trägergasstroms während der Oberflächenbeschichtung mit phasenweise erhöhter Geschwindigkeit erfolgt, ohne dabei die mittlere Geschwindigkeit des Trägergasstroms zu erhöhen.
